# FASCICULE DE BREVET EUROPEEN

(11) **EP 3 945 545 B1**
(45) Date de publication et mention de la délivrance du brevet: **26.04.2023**
(21) Numéro de dépôt: 21185360.1
(22) Date de dépôt: 13.07.2021
(51) Int. Cl.: H01L 21/24, H01L 31/0224, H01S 5/042, H01L 21/268, H01L 31/0312, H01S 5/32

(54) **PROCEDE DE FORMATION DE CONTACTS OHMIQUES, NOTAMMENT DE TYPE NI(GESN) METTANT EN OEUVRE UN RECUIT LASER**
VERFAHREN ZUR BILDUNG VON OHMSCHEN KONTAKTEN, INSBESONDERE DES NI(GESN)-TYPS, DURCH LASER-GLÜHEN
METHOD FOR FORMING OHMIC CONTACTS, IN PARTICULAR NI(GESN) TYPE, USING LASER ANNEALING

(30) Priorité: 31.07.2020 FR 2008175
(43) Date de publication de la demande: 02.02.2022
(73) Titulaire: Commissariat à l'énergie atomique et aux énergies alternatives, 75015 Paris (FR)
(72) Inventeur: QUINTERO COLMENA, Andréa-Carolina, 38054 GRENOBLE CEDEX 09 (FR); ACOSTA ALBA, Pablo, 38054 GRENOBLE CEDEX 09 (FR); RODRIGUEZ, Philippe, 38054 GRENOBLE CEDEX 09 (FR)
(74) Mandataire: Brevalex

(56) Documents cités:
- SCHULTE-BRAUCKS CHRISTIAN ET AL: "Schottky barrier tuningviadopant segregation in NiGeSn-GeSn contacts", JOURNAL OF APPLIED PHYSICS, AMERICAN INSTITUTE OF PHYSICS, US, vol. 121, no. 20, 31 mai 2017 (2017-05-31) , XP012219285, ISSN: 0021-8979, DOI: 10.1063/1.4984117 [extrait le 2017-05-31]

## Description

### DOMAINE TECHNIQUE ET ART ANTERIEUR

L'invention concerne la réalisation de contacts ohmiques, notamment de type Ni(GeSn) (alliage de nickel, de germanium et d'étain).

Elle trouve application dans le domaine des matériaux semiconducteurs, des dispositifs électroniques et des dispositifs optoélectroniques.

L'élaboration connue d'un contact inter-métallique de type Ni(GeSn) met en oeuvre un traitement par recuit thermique rapide (ou « RTA »), à des températures comprises entre 200 et 350° C, pour une durée de recuit comprise entre 30 et 60 secondes. On constate cependant une densité élevée de défauts et une faible stabilité thermique des couches obtenues par ce type de procédé, ce qui se traduit par l'agglomération de Ni(GeSn) et la ségrégation de l'étain (Sn). C'est en particulier le cas pour des températures proches de 350°C, ce qui peut nuire fortement aux propriétés électriques, mais également optiques. Dans le cas des dispositifs optiques, l'agglomération d'étain (Sn) pose le problème supplémentaire que les propriétés optiques sont affectées. Par exemple, le GeSn est utilisé comme couche émettrice dans des dispositifs laser. L'ajout d'étain dans le germanium permet de modifier les propriétés de bande de ce dernier et de rendre le « gap » direct. Or l'agglomération de l'étain (Sn) modifie la composition de la couche de GeSn (on tend alors vers du germanium pur) et modifie ainsi les propriétés des bandes électroniques.

Le traitement par recuit thermique rapide (ou « RTA ») ne permet donc pas d'obtenir un contact ohmique de type Ni(GeSn) de qualité satisfaisante (ces contacts manquent de stabilité thermique), présentant des qualités électriques (faible résistivité et une faible résistance carrée (Rₛₕ)) et/ou optiques adaptées.

Il se pose donc le problème de trouver un nouveau procédé de réalisation de contact ohmique de type Ni(GeSn), présentant des propriétés électriques et/ou optiques satisfaisantes. En particulier, un tel procédé évite la ségrégation des atomes de Sn et améliore la stabilité thermique du dispositif.

Le document SCHULTE-BRAUCKS CHRISTIAN ET AL: "Schottky barrier tuning via dopant ségrégation in NiGeSn-GeSn contacts",JOURNAL OF APPLIED PHYSICS, AMERICAN INSTITUTE OF PHYSICS, US, vol. 121, no. 20, 31 mai 2017 (2017-05-31), XP012219285,ISSN: 0021-8979, DOI: 10.1063/1.4984117 divulgue un procédé de fabrication d'un contact intermétallique de type Ni(GeSn).

### EXPOSE DE L'INVENTION

L'invention a d'abord pour objet un procédé de réalisation de contact ohmique comportant, ou consistant en, un métal, un semi-conducteur et de l'étain, dont la concentration est de préférence inférieure à 20%, mis en oeuvre par un recuit par laser. Selon un premier aspect de l'invention, un tel procédé comporte :
a) la formation d'une première couche, d'un alliage du semi-conducteur et de l'étain;
b) puis, sur la première couche, la formation d'une deuxième couche dudit métal ;
c) un recuit laser de la première couche, par exemple à une densité d'énergie qui peut être comprise entre 0.1 et 0.8 J/cm² ou même entre 0.1 et 2 J/cm².

Le matériau semi-conducteur peut être du Silicium ou du Germanium.

Le métal est par exemple choisi parmi le nickel (Ni), le cobalt (Co), le titane (Ti), le platine (Pt), l'alliage nickel-platine (NiPt), l'alliage nickel-cobalt (NiCo), le tantale (Ta), le nitrure de tantale (TaN), le nitrure de titane (TiN), l'aluminium (AI), le zirconium (Zr), l'ytterbium (Yb).

Dans le cas du système Ni/GeSn, le procédé selon l'invention permet d'obtenir une phase de nickel, de germanium et d'étain (Ni(GeSn)) faiblement résistive, avec de très bonnes propriétés électriques et sans ségrégation des atomes d'étain (Sn), la stabilité thermique du contact étant améliorée par rapport à celle résultant d'un traitement de type « RTA ». Avantageusement, un tel procédé comporte en outre, après l'étape b) et avant l'étape c), la formation d'une couche métallique faiblement résistive de protection et d'absorption du faisceau laser, par exemple en nitrure de titane (TiN) ou en nitrure de tantale (TaN).

La première couche, en un alliage du semi-conducteur et d'étain, peut être obtenue par croissance épitaxiale sur un substrat dudit semi-conducteur.

La densité d'énergie du laser peut par exemple être comprise entre 0.45 et 0,66 J/cm² ou 0.7 J/cm².

Un procédé selon l'invention peut comporter en outre, après l'étape c), une étape de recuit thermique rapide, de préférence à basse température, par exemple à une température comprise entre 150°C et 250°C.

Avantageusement, un tel procédé comporte, entre les étapes a) et b), une étape d'amorphisation de la première couche.

Cette étape d'amorphisation peut être obtenue par implantation d'une ou plusieurs espèces atomiques, par exemple du carbone (C) et/ou du germanium (Ge) et/ou du silicium (Si).

L'étape c) de recuit laser peut être réalisée à l'aide d'un laser impulsionnel, de longueur d'onde inférieure à 450 nm et/ou de largeur impulsionnelle comprise entre 10 ns et 300 ns. La densité d'énergie souhaitée peut être déposée en une ou en plusieurs impulsions. En variante, cette étape c) de recuit laser peut être réalisée à l'aide d'un laser continu, de longueur d'onde inférieure à 450 nm.

Un procédé selon l'invention peut en outre comporter, avant l'étape b), une étape de dopage de la première couche, et éventuellement du substrat dudit semi-conducteur. Dans le cas d'une première couche en GeSn, éventuellement sur un substrat en germanium, la couche en GeSn, et éventuellement la couche en germanium, peut/peuvent être dopée(s), par exemple par du bore ou du phosphore,

Un procédé selon l'invention peut en outre comporter une étape préalable de détermination ou d'estimation de la limite ou de la température de fusion de l'alliage du semi-conducteur et de l'étain, limite ou température de fusion que l'on cherche à atteindre par recuit laser.

La première couche, d'un alliage du semi-conducteur et d'étain, et éventuellement ledit substrat semi-conducteur, peut/peuvent être réalisée(s) sur un substrat en silicium, ce substrat faisant par exemple partie d'un composant optique ou d'un dispositif CMOS.

### BREVE DESCRIPTION DES DESSINS

Des exemples de réalisation de l'invention seront maintenant décrits en référence aux dessins annexés dans lesquels :
Les figures 1A, 1B représentent un exemple de procédé selon l'invention.
La figure 2 représente les résultats d'une simulation d'un traitement par laser d'un empilement silicium/germanium/nickel/nitrure de titane (Si/Ge/Ni/TiN).
Les figures 3A, 3B représentent l'évolution de la résistance de feuilles Rsh pour un échantillon Ni(GeSn) traité par un recuit classique de type RTA (figure 3A) et par un recuit par laser (figure 3B).
Les figures 4A, 4B représentent des mesures par diffraction pour un système Ni/GeSn traité à différentes températures par un recuit classique de type RTA (figure 4A) et à différentes densités d'énergie par un recuit par laser (figure 4B).
Les figures 5A, 5B représentent l'évolution morphologique du système Ni/GeSn en fonction de l'évolution de la température pour un contact obtenu par un recuit classique de type RTA (figure 5A) et pour un contact obtenu par recuit par laser (figure 5B).
Les figures 6A, 6B, 6C représentent une variante d'un procédé selon l'invention, comportant un recuit laser suivi d'un traitement RTA.
La figure 6D] représente l'évolution de la résistance Rsh pour un échantillon Ni(GeSn) traité par un recuit par laser, sans et avec recuit postérieur de type RTA à basse température.
Les figures 7A, 7B, 7C représentent une autre variante d'un procédé selon l'invention, comportant une pré-amorphisation par implantation avant métallisation.
Les figures 8A, 8B ,8C ,8D représentent encore une autre variante d'un procédé selon l'invention, comportant une pré-amorphisation par implantation avant métallisation et un recuit de type RTA à basse température post recuit laser ;

Dans les figures des éléments techniques similaires ou identiques sont désignés par les mêmes numéros de référence.

### DESCRIPTION DETAILLEE DE MODES DE REALISATION

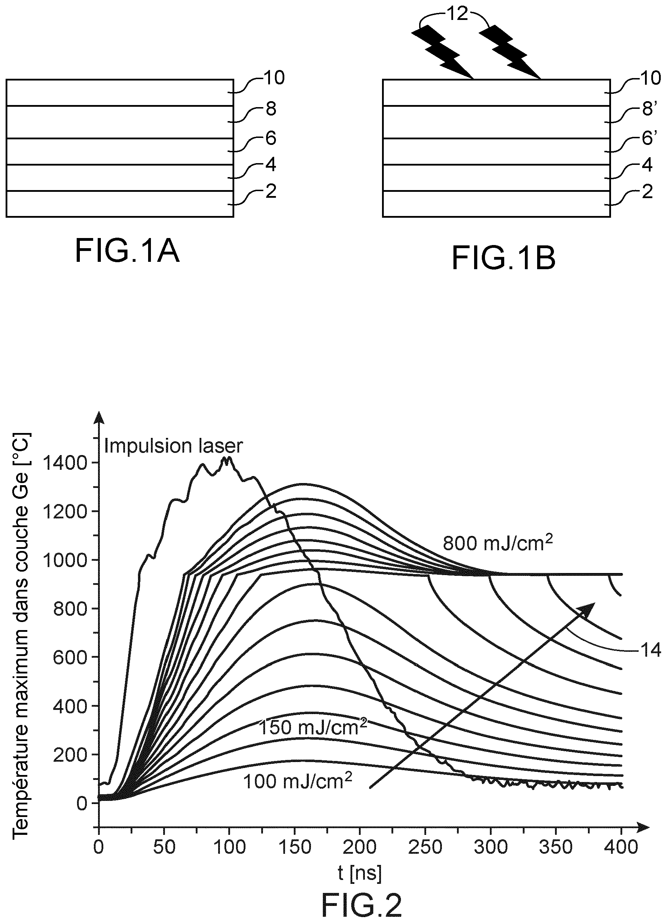

Un exemple de réalisation d'un procédé selon l'invention est représenté en figures 1A et 1B, pour réaliser un contact ohmique Ni(GeSn).

Un empilement comprenant une couche en alliage germanium-étain (GeSn) 6 et une couche de nickel (Ni) 8 est d'abord réalisé sur un substrat 2, par exemple en silicium (figure 1A) ce substrat 2 pouvant être par exemple en Silicium massif ou un SOI («Silicon on Insultor ») et pouvant faire partie du composant sur lequel un tel contact est réalisé.

La couche en alliage germanium-étain (GeSn) 6, d'épaisseur par exemple comprise entre 10 nm et 1 µm, peut être réalisée par épitaxie sur une couche 4 de germanium (d'épaisseur plusieurs µm, par exemple comprise entre 2 µm et 10 µm, par exemple encore 2,5 µm), elle-même supportée par le substrat en silicium 2. La concentration d'étain dans le germanium est par exemple d'environ 10%, plus généralement comprise entre 2% et 20% ou encore comprise entre 8% et 15% (notamment pour des applications optiques, tel qu'un laser GeSn).

La couche 6 et la couche 4 peuvent être dopées, par exemple par du bore ou du phosphore, par exemple encore à une dose comprise entre 10¹⁸ et 10²⁰ at/cm³, par exemple 10¹⁹ at/cm³.

La couche de nickel (Ni) 8 peut avoir une épaisseur de plusieurs nm ou de plusieurs dizaines de nm, par exemple comprise entre 5 nm et 50 nm, par exemple encore de 10 nm.

L'ensemble est surmonté d'une couche métallique 10, par exemple en nitrure de titane (TiN) ou nitrure de tantale (TaN). Cette couche métallique 10 a une épaisseur de plusieurs nm ou de plusieurs dizaines de nm, par exemple comprise entre 5 nm et 50 nm, par exemple 7 nm. Cette couche est une couche de protection, mais elle a aussi pour fonction d'absorber l'essentiel du faisceau laser et de la chaleur déposée par le laser, chaleur qui diffuse ensuite vers l'empilement, et notamment vers les couches de nickel 8 et d'alliage germanium-étain (GeSn) 6.

Cet ensemble est soumis à un recuit à l'aide d'un faisceau laser 12 (figure 1B), qui permet d'atteindre la température de fusion de l'alliage concerné, ici le GeSn. Il peut s'agir d'un laser impulsionnel. La densité d'énergie déposée est comprise entre 0,4 J/cm² et 0,7 J/cm², de préférence entre 0,48 et 0,66 J/cm². Cette densité d'énergie est mesurée ou estimée dans le plan de la surface supérieure de la couche 10. Par exemple, elle peut être mesurée ou estimée en déviant (à chaque impulsion dans le cas d'un laser impulsionnel) une partie du faisceau vers une photodiode.

Le laser est par exemple un laser XeCI (308 nm), ayant des impulsions de 160 ns (FWHM), ayant une densité d'énergie comprise entre 0,08 et 0,66 J/cm².

Une seule impulsion peut être mise en oeuvre pour déposer la densité surfacique d'énergie choisie ; en variante, plusieurs impulsions peuvent être utilisées, pour déposer, au total, la même densité surfacique d'énergie qu'une seule impulsion ou une densité surfacique d'énergie permettant d'obtenir des résultats identiques ou comparables à ceux obtenus avec une seule impulsion. En variante, il est possible d'utiliser un laser continu, lequel irradie la surface de la couche métallique 10 pendant une durée permettant de déposer la densité d'énergie souhaitée.

Le résultat du recuit est la structure présentée en figure 1B, comportant une couche en alliage de nickel, de germanium et d'étain (Ni(GeSn)) 8' au-dessus de la couche en alliage germanium-étain (GeSn) 6', cette dernière étant de même composition que la couche initiale 6, mais d'épaisseur inférieure puisqu'une partie de cette dernière a été consommée.

Selon un exemple de réalisation particulier :
- la couche en alliage germanium-étain (GeSn) 6 est réalisée par épitaxie sur une couche de germanium (Ge) 4, elle-même réalisée sur un substrat 2 en silicium (100), par exemple l'épitaxie de la couche en alliage germanium-étain (GeSn) 6 est réalisée dans un appareil de RPCVD (« Reduced Pressure Chemical Vapor Déposition ») ou dans un appareil de type MBE (« Molecular Beam Epitaxy ») ;
- puis une étape de nettoyage et de désoxydation peut être réalisée ; par exemple, cette couche est trempée pendant 1 minute dans un bain de HF (acide fluorhydrique) dilué à 1 % dans de l'eau ; elle est ensuite rincée à l'aide d'eau déionisée et séchée avec un canon à azote ;
- une étape de dopage de la couche 6 et la couche 4 peut être réalisée, par exemple par du bore ou du phosphore, par exemple encore à une dose comprise entre 10¹⁸-10²⁰ at/cm³, par exemple 10¹⁹ at/cm³ ;
- une couche de nickel (Ni) 8 est ensuite déposée, suivie d'une couche supérieure 10 d'un matériau de protection, de préférence un métal, tel que du nitrure de titane (TiN) ou du nitrure de tantale (TaN) (d'épaisseur par exemple d'environ 7 nm), le tout à température ambiante, par technique PVD (« Physical Vapor Déposition ») ou EBE (« Electron Beam Evaporation ») ;
- on utilise par exemple un laser XeCl (308 nm), ayant des impulsions de 160 ns (FWHM), avec une densité d'énergie déposée comprise entre 0,08 et 0,66 J/cm².

On étudie ci-dessous les propriétés d'un tel empilement TiN/Ni/GeSn/Ge/Si soumis à un traitement laser. Des comparaisons sont réalisées avec un empilement soumis à un procédé RTA classique.

La limite de fusion de l'alliage semi-conducteur - étain (GeSn dans l'exemple donné ci-dessus), que l'on cherche à atteindre dans la cadre du procédé selon l'invention, peut ne pas être préalablement connue. C'est le cas, par exemple, pour un nouvel empilement (notamment pour un nouveau matériau et/ou une nouvelle épaisseur d'une des couches de ce dernier). On peut donc réaliser préalablement une détermination ou une estimation de cette limite (ou température) de fusion, et de la densité d'énergie qui permet d'atteindre cette limite, par exemple par des simulations numériques. Le résultat obtenu par simulation peut être affiné expérimentalement.

Un procédé selon l'invention peut donc comporter une étape préalable de détermination ou d'estimation de la limite de fusion de l'alliage du semi-conducteur et de l'étain (que l'on cherche à atteindre par le recuit laser), et de la densité d'énergie correspondante. On donne ici un exemple de simulation numérique réalisée afin d'évaluer la limite de fusion, pour un empilement comportant:
- un substrat de silicium (Si) d'épaisseur 750 µm ;
- une couche de germanium (Ge) d'épaisseur 2,5 µm ;
- une couche de nickel (Ni) d'épaisseur 10 nm ;
- une couche de nitrure de titane (TiN) d'épaisseur 7 nm.

Dans le cadre de cette simulation, on considère que cet empilement est soumis à un recuit laser, pour des densités d'énergie comprises entre 0,1 J/cm² et 0,8 J/cm² (la flèche 15 de la figure 2 indique le sens croissant de la densité d'énergie). Ces simulations indiquent une fusion aux alentours de 0,4 - 0,45 J/cm², limite à laquelle les courbes (voir figure 2) présentent un plateau. À ces valeurs, on atteint sensiblement la température de fusion du germanium, et des contacts peuvent être obtenus, l'énergie du système étant suffisante pour permettre la diffusion des atomes d'étain et la croissance de la phase intermétallique. Selon ces simulations, la gamme de densité d'énergie qui présente un intérêt est donc, dans cet exemple, sensiblement comprise entre 0,4 J/cm² et 0,6 J/cm², ce qui peut être affiné expérimentalement. Ce type de simulation, présenté ci-dessus dans le cas d'une couche de germanium (Ge), peut être transposé à l'alliage germanium-étain (GeSn); ou bien, les résultats ci-dessus peuvent être affinés expérimentalement pour une application à l'alliage germanium-étain (GeSn).

Le recuit laser permet, à partir d'un empilement tel que celui de la figure 1A, de réaliser des composants inter-métalliques Ni(GeSn) ayant de très bonnes propriétés électriques pour former un contact ohmique tout en conservant une très bonne stabilité thermique et en limitant, ou même en supprimant, le phénomène de ségrégation de l'étain (Sn).

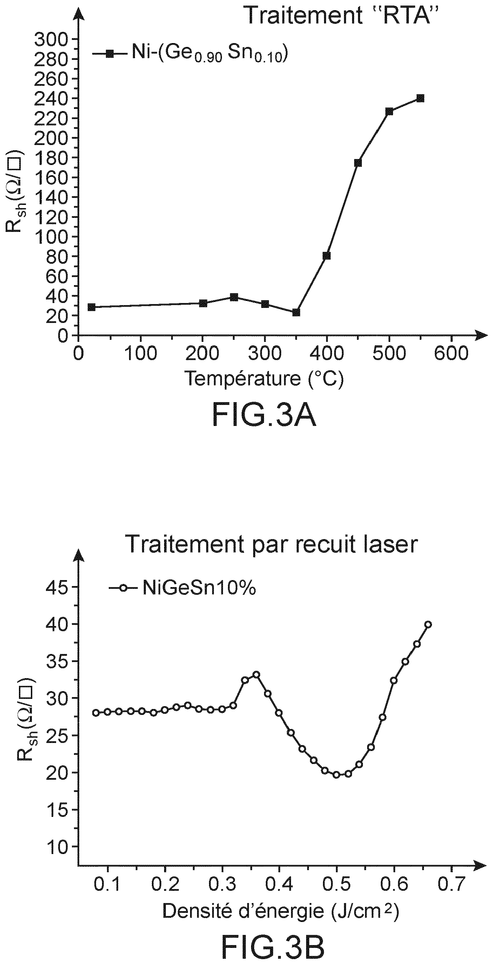

On a représenté, en figures 3A et 3B, l'évolution de la résistance carrée Rsh pour le système Ni/GeSn traité, d'une part, par un recuit classique de type RTA (figure 3A) et, d'autre part, par un recuit par laser (figure 3B).

On constate que l'évolution de ce paramètre électrique est sensiblement la même pour les deux échantillons :
- la valeur de résistance carrée reste d'abord stable, à environ 28-30 Ω /□, jusqu'à une légère augmentation due à la croissance de la phase riche en nickel, à environ 250° C pour les échantillons traités par RTA (figure 3A) et à environ 0,34 J/cm² pour les échantillons traités par laser (figure 3B) ;
- ensuite, la résistance carrée se réduit jusqu'à 350°C pour les échantillons traités par RTA (figure 3A) et jusqu'à environ 0,5 J/cm² pour les échantillons traités par laser (figure 3B) ; la réduction de la résistance carrée peut être liée à la croissance de la phase Ni(GeSn) ;
- enfin, la résistance carrée croît à partir d'environ 350°C pour les échantillons traités par RTA (figure 3A) et à partir d'environ 0,54 J/cm² pour les échantillons traités par laser (figure 3B) ; l'augmentation de la résistance carrée pour les échantillons traités par RTA (figure 3A) peut être liée à la ségrégation de l'étain et à l'agglomération de la couche Ni(GeSn), pour les échantillons traités par laser (figure 3B) cette croissance peut être liée à la dégradation de la couche de TiN. Il est à noter que la valeur de la résistance atteinte n'est pas la même pour les échantillons traités par RTA et pour les échantillons traités par laser.

L'augmentation de la résistance carrée est plus importante pour les échantillons traités par RTA que par laser : autrement dit, le traitement par RTA fait perdre une partie des propriétés de conduction de l'échantillon qui sont avantageuses pour former un contact électrique.

Concernant le traitement par laser (figure 3B), une densité d'énergie supérieure à 0,7 J/cm², dans cet exemple, dégrade l'empilement ; c'est la raison pour laquelle les résultats présentés s'arrêtent à une valeur légèrement inférieure à cette limite. Les résultats présentés ci-dessus concernent un exemple particulier d'empilement, aussi les valeurs, gammes et limite(s) indiquées pourront varier pour un autre exemple d'empilement. L'évolution illustrée en figure 3A est liée à la ségrégation du Sn et sa distribution en surface, ces 2 aspects dégradant de manière importante les propriétés électriques. Le recuit laser permet la formation d'un composé intermétallique Ni(GeSn) sans ségrégation du Sn, ce qui explique l'évolution plus favorable des propriétés électriques (figure 3B). Le recuit laser permet également d'obtenir un contact peu résistif sur une plus large gamme, en terme de densité d'énergie, que le traitement RTA, pour lequel il y a un seul point de fonctionnement (au-delà duquel l'étain subit une ségrégation).

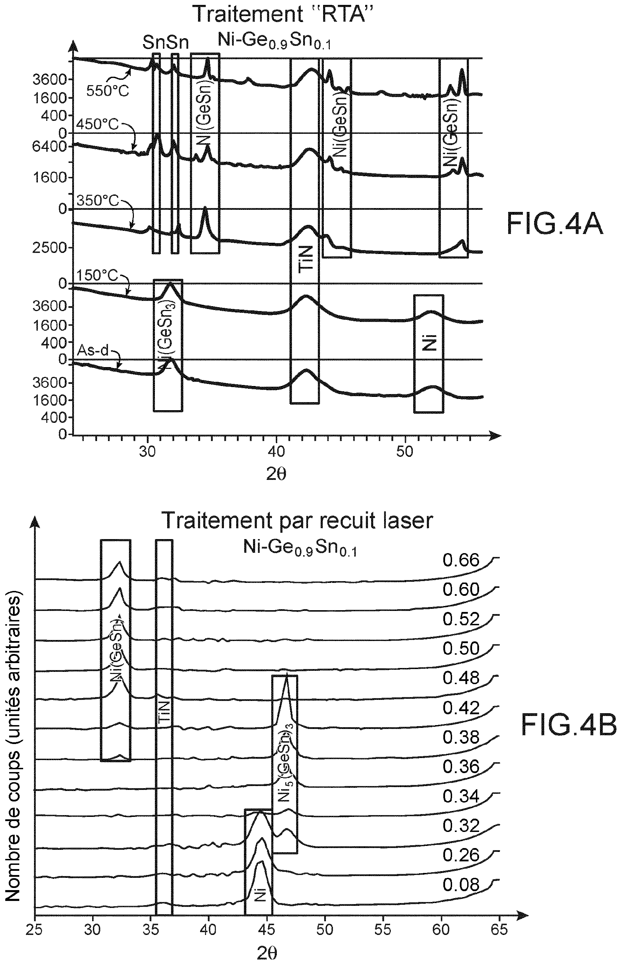

Ceci est confirmé par les figures 4A et 4B, qui montrent des résultats d'analyse en diffraction X (XRD), de type «Θ-2Θ», entre 20° et 90°, en utilisant une source de cuivre dans un diffractomètre à rayons X (de type X'Pert Pro PANalytical). Cette analyse permet de suivre l'évolution cristalline et la formation des phases dans l'échantillon. On a représenté, en figures 4A et 4B, l'évolution de l'intensité de la diffraction (en ordonnée, unités arbitraires) pour un système Ni/GeSn traité par un recuit classique de type RTA (figure 4A) et par un recuit par laser (figure 4B, sur laquelle la densité d'énergie, en J/ cm² est indiquée pour chaque courbe, depuis 0,08 J/cm² jusqu'à 0,66 J/cm²).

On voit donc, sur ces figures, l'évolution des phases du système Ni/GeSn dans les deux traitements. Cette évolution semble similaire, puisqu'on voit d'abord (à basse température en figure 4A et à faible densité d'énergie en figure 4B) la présence d'une phase Ni et, assez rapidement celle d'une phase riche en nickel Ni₅(GeSn)₃. Cette dernière est ensuite consommée lors de la croissance de la phase Ni(GeSn).

Mais, pour les échantillons traités par RTA (figure 4A), les pics de diffraction liés à la phase β-Sn et à la ségrégation et à l'agglomération du Sn sont également observés à partir de 350°C. Ce type de pic n'est pas observé pour les échantillons traités par laser, même à la plus haute densité d'énergie testée (0,66 J/cm²). Cette ségrégation du Sn dans le cas d'un traitement par RTA pose problème pour réaliser un contact ohmique de qualité, ne perturbant pas le fonctionnement du dispositif - notamment s'il est de type optique - auquel le contact est appliqué.

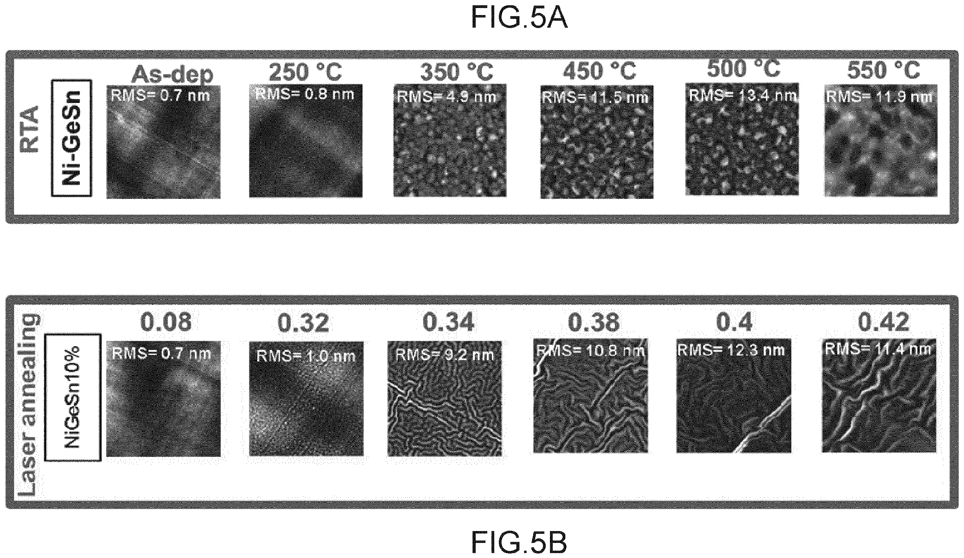

En plus du phénomène d'agglomération, des effets de rainurage par des joints de grain dégradent de manière importante les propriétés électriques du fait de la perte de continuité des couches. Des images (5µm × 5µm) réalisées par microscope à force atomique (AFM), en mode « Tapping », avec un équipement de type Bruker FastScan, ont permis d'étudier l'évolution morphologique de la surface de la couche 10 :
- en fonction de l'évolution de la température (de 250° C à 550° C) pour un recuit classique de type RTA : la figure 5A représente cette évolution (et celle de la rugosité, RMS) pour 6 échantillons, dont un échantillon tel que déposé (« As-dep ») et 5 échantillons, chacun traité à une température (mentionnée en figure 5A) comprise entre 250°C et 550°C;
- et en fonction de la densité d'énergie (de 0,08 à 0,42 J/cm²) de l'impulsion laser pour un recuit par irradiation laser : la figure 5B représente cette évolution (et celle de la rugosité, RMS) pour 6 échantillons, chacun traité avec une seule impulsion laser, de densité d'énergie (mentionnée en figure 5B) comprise entre 0,08 J/cm² et 0,42 J/cm², pour une concentration de 10% de Sn.

On voit donc, sur ces figures, l'évolution des phases du système Ni/GeSn dans les deux traitements.

Quel que soit le système étudié, à basse température (T<300 °C) pour les échantillons traités par RTA, et à faible densité d'énergie (<0,32 J/cm²) pour les échantillons traités par laser, on observe un motif de type « cross hatch » (« hachures en croix ») d'orientation cristallographique <110>. Ce motif résulte de la propagation des dislocations (sur les plans (111)). La morphologie de la surface est alors directement liée à l'épitaxie des couches GeSn.

Ceci signifie que, pour l'échantillon tel que déposé (Figure 5A, « As-dep »), les couches à base de nickel (Ni) et de construire de titane (TiN) ne modifient pas la morphologie de la surface d'origine.

Pour les systèmes traités seulement par RTA (Figure 5A), cette morphologie est préservée jusqu'à 300° C ; la formation de la phase riche en nickel ne modifie pas la morphologie d'origine.

Comme on le voit en figure 5A, la morphologie de la surface change radicalement à la température de 350° C, à laquelle on constate un accroissement élevé de la rugosité. Ces modifications sont liées à la formation de la phase Ni(GeSn) et à son agglomération.

À température supérieure à 350° C, la rugosité s'accroît graduellement du fait de l'amplification de deux phénomènes : l'agglomération de la phase Ni(GeSn) et la ségrégation de l'étain (Sn) (mise en évidence en figure 4A). L'accroissement élevé de la résistance Rₛₕ résulte également de ces deux phénomènes.

Pour les systèmes traités par laser (Figure 5B), le motif de type « cross hatch » est préservé à basse densité d'énergie. Au-delà de 0,34 J/cm², on constate une modification de la morphologie de surface : la rugosité s'accroît également, car on a passé la température de fusion du GeSn ; de plus, des plis sont observés sur cette surface, ce qui est dû à des variations de contraintes dans la couche de recouvrement TiN (par relaxation de cette couche) lors de la fusion de la couche Ni/GeSn sous-jacente. L'amplitude des plis dépend de la profondeur de matériau fondu ; cette dernière augmentant avec la densité d'énergie, l'amplitude des plis augmente également.

Notons que, dans le cas des systèmes traités par laser, ce sont ces plis qui entraînent une forte rugosité, mais que cela n'impacte pas les propriétés électriques; de plus, les mesures de diffraction (figures 4B) montrent qu'il n'y a pas de ségrégation de Sn. La pointe utilisée pour réaliser les images par AFM interagit dans un premier temps avec la couche de nitrure de titane (TiN), qui est fortement modifiée du fait de la relaxation des contraintes (déjà mentionnée ci-dessus). Mais les valeurs de Rsh ne sont pas élevées: la conductivité est donc bonne et la couche de Ni(GeSn) est probablement encore continue, bien que la rugosité de la couche de nitrure de titane (TiN) soit importante.

En outre, aucune trace de ségrégation de l'étain (Sn) n'est observée (des ilots de surface ont été seulement observés pour les échantillons traités par RTA).

Par conséquent, un recuit laser permet d'obtenir une phase Ni(GeSn), de faible résistivité, permettant de réaliser un contact sur des dispositifs à base de GeSn, avec un budget thermique réduit néanmoins compatible avec la formation de cette phase. De très bonnes propriétés électriques sont obtenues, sans ségrégation d'étain Sn en surface. Compte tenu des résultats des différents exemples discutés ci-dessus (figures 3A-5B), la formation d'un très bon contact ohmique est, pour ces exemples, obtenue pour une gamme de densité d'énergie déposée par le laser comprise entre 0,44 et 0,66 J/cm².

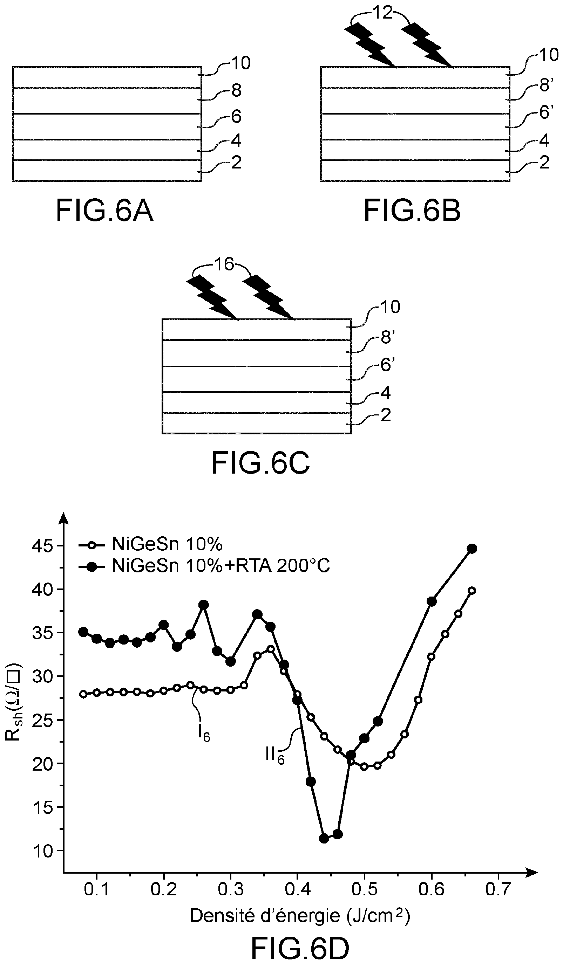

Un procédé selon l'invention peut être suivi d'un recuit à basse température, qui permet d'améliorer les propriétés électriques du contact ohmique obtenu par recuit laser, sans en dégrader la morphologie de surface. Un tel procédé est illustré de manière schématique en figures 6A-6C. Il comporte, dans cet ordre :
a) une croissance épitaxiale du GeSn sur un substrat de germanium ;
b) éventuellement un traitement de surface par HF ;
c) éventuellement un dopage de la couche de GeSn 6 et du substrat de germanium 4;
d) un dépôt de couches de nickel (Ni) et de nitrure de titane (TiN), pour former l'empilement de la figure 6A ;
e) un recuit laser (figure 6B);
f) un recuit rapide à basse température (figure 6C), par exemple comprise entre 150°C et 250°C.

Les étapes a) - e) de ce procédé sont celles déjà décrites ci-dessus.

L'étape f) de recuit à basse température permet de réduire la résistivité du contact obtenu et d'utiliser une densité surfacique d'énergie plus faible, voisine de 0,44 J/cm². Ainsi, on a représenté en figure 6D l'évolution de la résistance Rsh pour le système Ni/GeSn traité par un recuit par laser sans (courbe I₆) et avec (courbe II₆) un recuit RTA basse température (200°C) postérieur. On voit sur cette figure que le minimum de la courbe II₆ est inférieur à celui de la courbe I₆; de plus, il apparaît à une densité d'énergie inférieure (environ 0,44 J/cm² au lieu de 0,5 J/cm²)

Selon un autre aspect, une pré-amorphisation par implantation de la couche GeSn est réalisée lors de la préparation d'un empilement en vue de la mise en oeuvre d'un procédé selon l'invention, au cours duquel on estime qu'on atteint probablement la température de fusion du GeSn (avec Ge amorphisé). Cette pré-amorphisation permet d'améliorer la stabilité thermique de l'empilement ; elle utilise des espèces atomiques telles que le silicium (Si), le germanium (Ge), le carbone (C), isolément ou en combinaison. On préfère l'implantation d'espèces atomiques de taille plus petite, comme le carbone, qui peut mieux s'insérer dans la structure des alliages Niₓ(GeSn)_{y} et, ainsi, mieux bloquer la diffusion et la ségrégation de l'étain (Sn).

Puis, après cette pré-amorphisation, on forme la couche métallique 8 et la couche de protection 10. Enfin, l'empilement est traité par laser, conformément à l'invention.

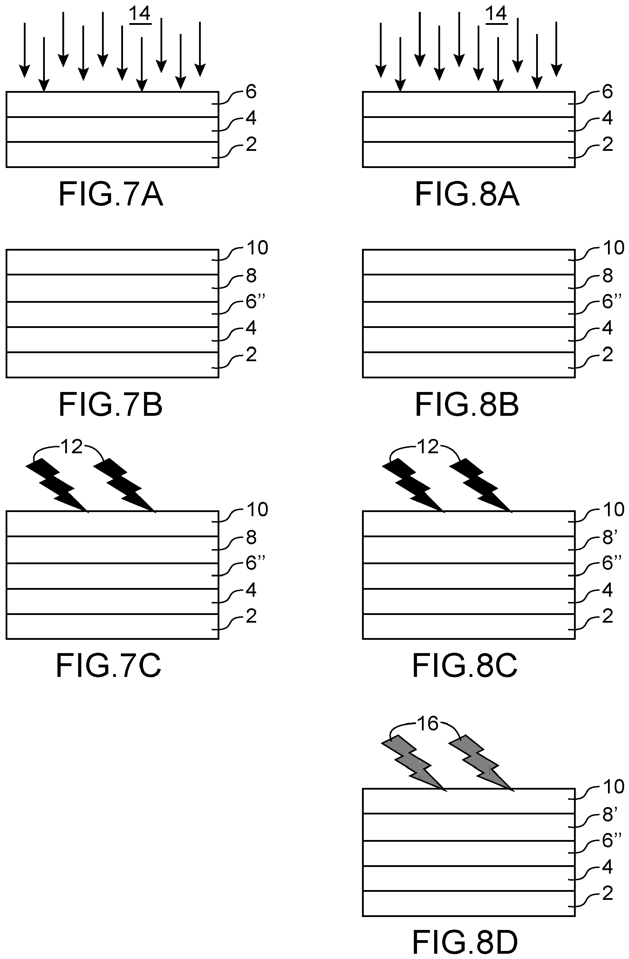

Un tel procédé est illustré de manière schématique en figures 7A-7C. Il comporte :
a) -une croissance épitaxiale du GeSn 6 sur un substrat de germanium 4;
b) éventuellement un traitement de surface par HF ;
c) éventuellement un dopage de la couche de GeSn 6 et du substrat de germanium 4;
d) une pré-amorphisation par implantation 14 (figure 7A), la couche de GeSn étant transformé en une couche amorphe α-GeSn 6";
e) un dépôt de couches de nickel (Ni) 8 et de nitrure de titane (TiN) 10 pour former l'empilement de la figure 7B ;
f) un recuit laser 12 (figure 7C) conformément à la présente invention.

Les étapes a)- c), e), f) de ce procédé sont celles déjà décrites ci-dessus.

En variante, il est possible de réaliser :
- un pré-amorphisation par implantation de la couche GeSn, comme décrit ci-dessus, en lien avec les figures 7A-7C, en utilisant des espèces telles que le silicium (Si), le germanium (Ge), le carbone (C), isolément ou en combinaison :
- puis, après cette pré-amorphisation, on forme la couche métallique 8 et la couche de protection 10 ;
- puis, l'empilement est traité par laser, conformément à l'invention ;
- ce recuit est suivi ici d'un traitement de type RTA à basse température, comme décrit ci-dessus, en lien avec les figures 6A-6C.

On cumule ainsi les effets avantageux des 2 traitements déjà exposés ci-dessus (figures 6A-6C, figures 7A-7C).

Un tel procédé est illustré de manière schématique en figures 8A-8D. Il comporte :
a) une croissance épitaxiale du GeSn 6 sur un substrat 4 de germanium;
b) éventuellement un traitement de surface par HF ;
c) éventuellement un dopage de la couche de GeSn 6 et du substrat de germanium 4;
d) une pré-amorphisation par implantation 14 (figure 8A), la couche de GeSn étant transformé en une couche amorphe α-GeSn 6";
e) un dépôt de couches 8 de Ni et 10 de TiN (figure 8B);
f) un recuit laser (figure 8C);
g) un recuit thermique à basse température (figure 8D).

Ces étapes a) - g) sont celles déjà décrites ci-dessus.

L'invention a été décrite pour la réalisation d'un contact Ni(GeSn), mais d'autres contacts ohmiques, de type comportant un métal, un semi-conducteur et de l'étain, peuvent également être réalisés, le matériau semi-conducteur étant par exemple du Silicium ou du Germanium, tandis que le métal est choisi parmi le nickel (Ni), le cobalt (Co), le titane (Ti), le platine (Pt), l' alliage nickel-platine (NiPt), l'alliage nickel-cobalt (NiCo), le tantale (Ta), le nitrure de tantale (TaN), le nitrure de titane (TiN), l'aluminium (AI), le zirconium (Zr), l'ytterbium (Yb). Pour chaque type de contact, on peut déterminer la limite (ou température) de fusion (voir le procédé expliqué ci-dessus), et/ou les limites de la gamme de densité surfacique d'énergie laser à appliquer pour obtenir les propriétés souhaitées. Des analyses telles que celle présentées ci-dessus pour la réalisation d'un contact Ni(GeSn) peuvent être réalisées en vue d'identifier la ségrégation, ou non, de l'étain (Sn). Les contacts ohmiques obtenus par l'invention sont adaptés :
- à la réalisation de composants optiques (par exemple pour des applications à des lasers, ou des applications aux capteurs dans le domaine de l'infra-rouge) ;
- à la réalisation de contact de type Source-drain de dispositifs CMOS à canal Ge(Sn).

Un contact obtenu par un procédé selon l'invention à une structure telle que celle illustrée en figures 1B, 6C, 7D ou 8D, la couche 2 de silicium faisant partie du composant sur lequel le contact est réalisé.

## Revendications

1. Procédé de réalisation de contact ohmique, comprenant un métal, un semi-conducteur et de l'étain, comportant :
a) la formation d'une première couche (6), d'un alliage du semi-conducteur et d'étain;
b) puis, sur la première couche, la formation d'une deuxième couche (8), dudit métal ;
c) un recuit laser (12) au moins de la première couche (6) à une densité d'énergie comprise entre 0.1 et 2J/cm².

2. Procédé selon la revendication 1, le matériau semi-conducteur étant du Silicium ou du Germanium.

3. Procédé selon la revendication 1 ou 2, le métal étant choisi parmi le nickel (Ni), le cobalt (Co), le titane (Ti), le platine (Pt), l'alliage nickel-platine (NiPt), l'alliage nickel-cobalt (NiCo), le tantale (Ta), le nitrure de tantale (TaN), le nitrure de titane (TiN), l'aluminium (AI), le zirconium (Zr), l'ytterbium (Yb).

4. Procédé selon l'une des revendications 1 à 3, la densité d'énergie du laser étant comprise entre 0.44 J/cm² et 0.7 J/cm².

5. Procédé selon l'une des revendications 1 à 4, comportant en outre, après l'étape c), une étape de recuit thermique rapide, de préférence à basse température, par exemple comprise entre 150°C et 250°C.

6. Procédé selon l'une des revendications 1 à 5, comportant, entre les étapes a) et b), une étape d'amorphisation de la première couche, l'étape d'amorphisation étant par exemple obtenue par implantation (14) d'une ou plusieurs espèces atomiques, par exemple de carbone (C), et/ou de germanium (Ge) et/ou de silicium (Si).

7. Procédé selon l'une des revendications 1 à 6, comportant en outre, après l'étape b) et avant l'étape c), la formation d'une couche métallique (10) de protection.

8. Procédé selon la revendication 7, la couche métallique de protection étant en nitrure de titane (TiN) ou en nitrure de tantale (TaN).

9. Procédé selon l'une des revendications 1 à 8, la première couche (6), en un alliage du semi-conducteur et d'étain, étant obtenue par croissance épitaxiale sur un substrat (4) dudit semi-conducteur.

10. Procédé selon l'une des revendications 1 à 9, le recuit laser (12) de la première couche (6) ayant une densité d'énergie comprise entre 0.1 et 0.8 J/cm².

11. Procédé selon l'une des revendications 1 à 10, l'étape c) de recuit laser étant réalisée à l'aide d'un laser impulsionnel, en une ou plusieurs impulsions, le laser impulsionnel ayant par exemple une longueur d'onde inférieure à 450 nm et/ou une largeur impulsionnelle à mi-hauteur comprise entre 10 ns et 300 ns.

12. Procédé selon l'une des revendications 1 à 11, comportant en outre une étape de dopage de la première couche (6), et éventuellement du substrat (4) dudit semi-conducteur.

13. Procédé selon l'une des revendications 1 à 12, comportant une étape préalable de détermination ou d'estimation de la limite de fusion de l'alliage du semi-conducteur et de l'étain.

14. Procédé selon l'une des revendications 1 à 13, la première couche (6), d'un alliage du semi-conducteur et d'étain, et éventuellement ledit substrat (4) semi-conducteur étant réalisée sur un substrat en silicium.

15. Procédé selon la revendication 14, ledit substrat en silicium faisant parti d'un composant optique ou d'un dispositif CMOS.

## Patentansprüche

1. Verfahren zur Herstellung eines ohmschen Kontakts, umfassend ein Metall, einen Halbleiter und Zinn, Folgendes beinhaltend:
a) Bilden einer ersten Schicht (6), aus einer Legierung aus dem Halbleiter und Zinn;
b) danach, auf der ersten Schicht, Bilden einer zweiten Schicht (8) aus dem Metall;
c) Laser-Glühen (12) mindestens der ersten Schicht (6) mit einer Energiedichte, die zwischen 0,1 und 2 J/cm² liegt.

2. Verfahren nach Anspruch 1, wobei das Halbleitermaterial Silicium oder Germanium ist.

3. Verfahren nach Anspruch 1 oder 2, wobei das Metall aus Nickel (Ni), Kobalt (Co), Titan (Ti), Platin (Pt), einer Nickel-Platin-Legierung (NiPt), einer Nickel-Kobalt-Legierung (NiCo), Tantal (Ta), Tantal-Nitrid (TaN), Titan-Nitrid (TiN), Aluminium (Al), Zirconium (Zr), Ytterbium (Yb) ausgewählt wird.

4. Verfahren nach einem der Ansprüche 1 bis 3, wobei die Energiedichte des Lasers zwischen 0,44 J/cm² und 0,7 J/cm² liegt.

5. Verfahren nach einem der Ansprüche 1 bis 4, das weiter nach dem Schritt c) einen Schritt des schnellen thermischen Glühens, vorzugsweise bei niedriger Temperatur, beispielsweise zwischen 150 °C und 250 °C liegend, beinhaltet.

6. Verfahren nach einem der Ansprüche 1 bis 5, das zwischen den Schritten a) und b) einen Schritt des Amorphisierens der ersten Schicht beinhaltet, wobei der Schritt des Amorphisierens beispielsweise durch Implantieren (14) einer oder mehrerer atomarer Spezies, beispielsweise Kohlenstoff (C), und/oder Germanium (Ge) und/oder Silicium (Si) erhalten wird.

7. Verfahren nach einem der Ansprüche 1 bis 6, das weiter nach dem Schritt b) und vor dem Schritt c) die Bildung einer Metallschutzschicht (10) beinhaltet.

8. Verfahren nach Anspruch 7, wobei die Metallschutzschicht aus Titan-Nitrid (TiN) oder aus Tantal-Nitrid (TaN) ist.

9. Verfahren nach einem der Ansprüche 1 bis 8, wobei die erste Schicht (6) aus einer Legierung aus dem Halbleiter und Zinn durch epitaktisches Wachstum auf einem Substrat (4) des Halbleiters erhalten wird.

10. Verfahren nach einem der Ansprüche 1 bis 9, wobei das Laser-Glühen (12) der ersten Schicht (6) eine Energiedichte aufweist, die zwischen 0,1 und 0,8 J/cm² liegt.

11. Verfahren nach einem der Ansprüche 1 bis 10, wobei der Schritt c) des Laser-Glühens mithilfe eines gepulsten Lasers in einem oder mehreren Impulsen durchgeführt wird, wobei der gepulste Laser beispielsweise eine Wellenlänge von weniger als 450 nm und/oder eine Impulsbreite auf halber Höhe aufweist, die zwischen 10 ns und 300 ns liegt.

12. Verfahren nach einem der Ansprüche 1 bis 11, das weiter einen Schritt des Dotierens der ersten Schicht (6) und eventuell des Substrats (4) des Halbleiters beinhaltet.

13. Verfahren nach einem der Ansprüche 1 bis 12, das einen vorhergehenden Schritt zum Bestimmen oder Schätzen der Schmelzgrenze der Legierung aus dem Halbleiter und Zinn beinhaltet.

14. Verfahren nach einem der Ansprüche 1 bis 13, wobei die erste Schicht (6) aus einer Legierung aus dem Halbleiter und Zinn, und eventuell das HalbleiterSubstrat (4) auf einem Substrat aus Silicium hergestellt werden.

15. Verfahren nach Anspruch 14, wobei das Substrat aus Silicium Teil eines optischen Bauteils oder einer CMOS-Vorrichtung ist.

## Claims

1. Method for producing ohmic contacts, comprising a metal, a semiconductor and tin, including:
a) forming a first layer (6), of an alloy of the semiconductor and of tin;
b) then, on the first layer, forming a second layer (8), of said metal;
c) laser annealing (12) at least the first layer (6) at an energy density between 0.1 and 2 J/cm²

2. Method according to claim 1, the semiconductor being silicon or germanium.

3. Method according to claim 1 or 2, the metal being selected from nickel (Ni), cobalt (Co), titanium (Ti), platinum (Pt), nickel-platinum (NiPt) alloy, nickel-cobalt (NiCo) alloy, tantalum (Ta), tantalum nitride (TaN), titanium nitride (TiN), aluminium (Al), zirconium (Zr), ytterbium (Yb).

4. Method according to any of claims 1 to 3, the energy density of the laser being between 0.44 J/cm² and 0.7 J/cm².

5. Method according to any of claims 1 to 4, further including, after step c), a step of rapid thermal annealing, preferably at low temperature, for example between 150°C and 250°C.

6. Method according to any of claims 1 to 5, including, between steps a) and b), a step of amorphising the first layer, the amorphisation step being for example obtained by implantation (14) of one or more atomic species, for example carbon (C), and/or germanium (Ge) and/or silicon (Si).

7. Method according to any of claims 1 to 6, further including, after step b) and before step c), forming a protective metal layer (10).

8. Method according to claim 7, the protective metal layer being made of titanium nitride (TiN) or tantalum nitride (TaN).

9. Method according to any of claims 1 to 8, the first layer (6), made of an alloy of the semiconductor and of tin, being obtained by epitaxial growth on a substrate (4) of said semiconductor.

10. Method according to any of claims 1 to 9, the laser annealing (12) of the first layer (6) having an energy density between 0.1 and 0.8 J/cm².

11. Method according to any of claims 1 to 10, step c) of laser annealing being performed with the aid of a pulse laser, in one or more pulses, the pulse laser having for example a wavelength lower than 450 nm and/or a pulse width at mid-height between 10 ns and 300 ns.

12. Method according to any of claims 1 to 11, further including a step of doping the first layer (6), and optionally the substrate (4) of said semiconductor.

13. Method according to any of claims 1 to 12, including a preliminary step of determining or estimating the melting limit of the alloy of the semiconductor and of tin.

14. Method according to any of claims 1 to 13, the first layer (6), of an alloy of the semiconductor and of tin, and optionally said semiconductor substrate (4) being produced on a silicon substrate.

15. Method according to claim 14, said silicon substrate forming part of an optical component or of a CMOS device.
